# EUROPÄISCHE PATENTSCHRIFT

(11) **EP 1 069 407 B1**
(45) Veröffentlichungstag und Bekanntmachung des Hinweises auf die Patenterteilung: **30.11.2005**
(21) Anmeldenummer: 00114361.9
(22) Anmeldetag: 05.07.2000
(51) Int. Cl.: G01D 3/08, G01R 31/28

(54) **Elektronische Gebereinrichtung**
Electronic sensor
Capteur électronique

(30) Priorität: 15.07.1999 DE 19933096; 23.02.2000 DE 10008180
(43) Veröffentlichungstag der Anmeldung: 17.01.2001
(73) Patentinhaber: Micronas GmbH, 79108 Freiburg (DE)
(72) Erfinder: Motz, Mario, Dipl.-Ing., 9241 Wernberg (AT); Theus, Ulrich, Dr., 79194 Gundelfingen (DE)

(56) Entgegenhaltungen:
- DE-A- 19 751 519
- US-A- 5 473 253

## Beschreibung

Die Erfindung betrifft eine elektronische Gebereinrichtung. Derartige Gebereinrichtungen enthalten oft einen Sensor zur Messung eines äußeren Zustandes, der mittels des Gebers als elektrisches Signal einer Signalerkennungseinrichtung zugeführt wird. Sehr störend sind bei derartig exponierten Gebern Unterbrechungen der Versorgungszuleitungen, insbesondere eine Unterbrechung der Massezuleitung. Derartige Unterbrechungen müssen in vielen Fällen von der Signalererkennungseinrichtung erkannt werden, um nicht fehlerhaft als korrektes Gebersignal interpretiert zu werden.

Derartige Gebereinrichtungen werden beispielsweise ersatzweise für Potentiometeranordnungen verwendet, mit denen die jeweilige Position einer mechanischen Stelleinrichtung von einer elektronischen Verarbeitungseinrichtung, z.B. einem Prozessor, abgefragt werden kann. Breite Anwendungen finden sich beispielsweise im Kraftfahrzeug, wenn die Stellung von Motorsteuereinrichtungen, Bremsen, Scheinwerfern, Sitzen usw. auszuwerten oder zu speichern sind. Da der mechanische Verschleiß derartiger Potentiometeranordnungen im Laufe der Zeit zu fehlerhaften Messungen oder gar Betriebsausfällen führen kann, werden zunehmend berührungsfreie Meßverfahren unter Verwendung von Sensoren zur Erfassung der jeweiligen Position verwendet. Eine ähnliche Anwendung derartiger Gebereinrichtungen betrifft die Messung und Weitergabe von Temperatur, Druck, Feuchtigkeit, Helligkeit und anderen physikalischen Größen über entsprechende Sensoren.

In DE 197 51 519 A1 ist beispielsweise eine Gebereinrichtung mit einem Hallsensor für einen Linearsensor beschrieben, der zwei gegeneinander verschiebbare mechanische Teile enthält, deren Relativposition durch die Gebereinrichtung gemessen wird. Die Gebereinrichtung enthält eine Fehlermeldeschaltung zur Ausgabe eines definierten Spannungssignals bei Unterbrechung der Masseverbindung. Die Unterbrechung einer der drei Anschlußleitungen der Gebereinrichtung kann in den vorgesehenen Anwendungsfällen im Kraftfahrzeug leicht auftreten, weil der Linearsensor hohen Vibrationen ausgesetzt ist und die Gebereinrichtung über drei Anschlußleitungen mit einer Steckverbindung auf dem Linearsensor verbunden sind, von der aus dann drei Leitungen an die Auswerte- und Versorgungsschaltung gehen. Die Fehlermeldeschaltung enthält einen steuerbaren Widerstand, einen n-Kanal-Depletion-MOS-Feldeffekt-Transistor, der zwischen die positive Betriebsspannungsleitung und die Ausgangsleitung der Gebereinrichtung geschaltet ist. Die Gate-Elektrode des Depletion-Transistors ist mittels eines von der Betriebsspannung gespeisten Gleichspannungswandlers im normalen Betriebszustand - also ohne Leitungsunterbrechung - auf ein ausreichend tiefes Potential gelegt, so daß der Depletion-Transistor sperrt. Das Gate-Potential liegt dabei beispielsweise 1 V unterhalb des Massepotentials. Bei einer Unterbrechung der Masseleitung ist der Gleichspannungswandler außer Funktion und seine Ausgangsspannung entspricht damit der Betriebsspannung. Dadurch befindet sich der Depletion-Transistor im voll leitenden Zustand, so daß dieser das Potential der Ausgangsleitung etwa auf das Potential der Betriebsspannung hochzieht, was für die Signalerkennungseinrichtung als fehlerhaftes Signal erkennbar ist. Die Unterbrechung der Betriebsspannungsleitung ist weniger kritisch, weil in diesem Fall der Geberausgang das Massepotential annimmt, das auf der Empfangsseite leicht als fehlerhaftes Signal erkennbar ist. Es wird ferner angegeben, daß die gesamte Gebereinrichtung mit Fehlermeldeschaltung auch als mikroelektronischer Schaltkreis integrierbar ist und dies eine bevorzugte Ausgestaltung darstellt.

In EP 0 648 019 A2 ist ein monolithisch integrierter Spannungsregler in CMOS-Technik beschrieben, der als Verpolungsschutz eine in Reihe zum Spannungsregler geschaltete MOS-Transistorstruktur enthält, die im Verpolungsfall den resultierenden Verpolungsstrom soweit reduziert, daß eine Zerstörung der monolithisch integrierten Schaltung verhindert wird. Ferner enhält das beschriebene Ausführungsbeispiel auch Schaltungsmaßnahmen, um den Betrieb an einer Versorgungsspannung zu ermöglichen, deren Spannung höher ist, als nach dem zugrundeliegenden Herstellungsstandard, beipielsweise eine standardisierte CMOS-Technik, an sich zulässig wäre.

Der Erfindung liegt die **Aufgabe** zugrunde, die bekannte Gebereinrichtung an einen standardisierten Herstellungsprozeß für monolithisch integrierte Schaltungen, insbesondere ein CMOS-Herstellungsprozeß, anzupassen. Als eine zusätzliche Aufgabe sind Vorkehrungen zu treffen, die eine Zerstörung der monolithisch integrierten Schaltung beim Anlegen einer Überspannung und/oder bei der Vertauschung oder Verpolung der Anschlüsse verhindern.

Als **Lösung** wird vorgeschlagen, daß in der monolithisch integrierten Gebereinrichtung außer der üblichen Betriebsschaltung ein von einer Ladungspumpe gesteuerter p-Kanal-Depletion-Transistor in einer eigenen n-Wanne zwischen den Betriebsspannungsanschluß und den Signalausgang eingefügt ist, der im normalen Betriebsfall, bei dem die Betriebsspannung und das Massepotential an der Gebereinrichtung und damit an der Ladungspumpe anliegen, gesperrt und bei Unterbrechung der Massezuleitung leitend ist. Die n-Wanne im p-leitenden Substrat ist über einen mitintegrierten Widerstand mit dem Betriebsspannungsanschluß verbunden. Die Ladungspumpe und der Depletion-Transistor bilden die Fehlermeldeschaltung. Durch die Verwendung des p-Kanal-Depletion-Transistors in der eigenen Wanne wird erreicht, daß dieser Transistor mit einer positiven Spannung gesperrt werden kann und damit alle Spannungen höher als das Potential am Substrat der monolithisch integrierten Schaltung sind.

Der Schutz der Gebereinrichtung gegen das Vertauschen der Anschlüsse beim Anlegen der Betriebsspannung ist bei der Umsetzung der Gebereinrichtung in eine monolithisch integrierte Schaltung zu beachten. Denn durch eine falsch angelegte Betriebsspannung werden in der monolithisch integrierten Schaltung ansonsten gesperrte Zonen in Flußrichtung gebracht, die unter Umständen einen hohen Stromfluß zur Folge haben, der letztendlich zur Zerstörung des Bauelements führt. Um den vorgesehenen Schutz gegen das Vertauschen der Anschlüsse der Betriebsspannung zu ermöglichen, sieht die Erfindung vor, daß die n-Wanne des MOS-Depletion-Transistors nicht wie üblich direkt, sondern über einen mitintegrierbaren Widerstand mit dem Betriebsspannungsanschluß verbunden ist. Ein im Verpolungsfall über die Wanne fließender Strom wird somit mindestens durch diesen Widerstand begrenzt. Damit ist der zwischen dem Betriebsspannungsanschluß und dem Signalausgang liegende Depletion-Transistor auch gegen das versehentliche Anlegen der Betriebsspannung an den Signalausgang geschützt.

Um eine Unterbrechung der Betriebsspannungzuleitung auf der Empfängerseite zu erkennen, sieht eine Weiterbildung der Erfindung vor, daß der Signalausgang der Gebereinrichtung und/oder der Signaleingang der Empfangseinrichtung über einen mitintegrierten oder externen Widerstand mit dem Massepotential verbunden ist, der den Signalausgang unabhängig von parasitären Strömen oder Kapazitäten rasch auf das Massepotential zieht. Mittels des Widerstandes nach Masse am Signaleingang der Empfangseinrichtung wird dort auch eine Unterbrechung der externen Signalleitung als fehlerhafter Betrieb der gesamten Anordnung sicher erkannt. Die Widerstände nach Masse sind dabei wesentlich hochohmiger als der Innenwiderstand der Gebereinrichtung.

Falls die Betriebsspannung höher als die von der jeweiligen Schaltungstechnologie vorgegebenen Grenzspannungswerte sind, also auch im Fall kurzzeitiger Überspannungen, die beispielsweise während des Betriebs in einem Kraftfahrzeug auftreten können, soll der Depletion-Transistor vor zu hohen Spannungen geschützt werden. Hierfür sieht eine bevorzugte Weiterbildung der Erfindung vor, daß die zu hohe Spannung auf zwei in Reihe geschaltete p-Kanal-Depletion-Transistoren aufgeteilt wird. Im normalen Betriebsfall befindet sich der eine im Sperrzustand und der andere ist als Kaskodetransistor geschaltet und damit leitend. Sein Gate wird über eine die Kaskodesteuerspannung erzeugende Ansteuerschaltung gesteuert, deren Ausgangsspannung etwa hälftig zwischen dem jeweiligen Betriebsspannungs- und Massepotential liegt, so daß die zu hohe Betriebsspannung etwa zu gleichen Teilen auf die beiden p-Kanal-Depletion-Transistoren augeteilt wird. Wird die Masseleitung unterbrochen, dann sind durch die fehlenden Ansteuerspannungen beide p-Kanal-Depletion-Transistoren leitend und ziehen den Signalausgang etwa auf die anliegende Betriebsspannung hoch. Für den Schutz der übrigen Schaltung gegen eine zu hohe Betreibsspannung werden zweckmäßigerweise ebenfalls Kaskodestufen verwendet, die beispielsweise in der bereits genannten eigenen europäischen Patentanmeldung EP-0 648 019 A2 ausführlich beschrieben sind. Eine nochmalige Beschreibung erübrigt sich daher.

Die Erfindung und vorteilhafte Weiterbildungen werden nachstehend anhand der Figuren der Zeichnung näher erläutert. Hierbei stellen dar:
- Fig. 1: als Blockschaltbild eine erfindungsgemäße Gebereinrichtung,
- Fig. 2: ein Schaubild der Ausgangsspannung,
- Fig. 3: in Schnittansicht den MOS-Depletion-Transistor von Fig.1 und
- Fig. 4: ein Beispiel für den Überspannungsschutz.

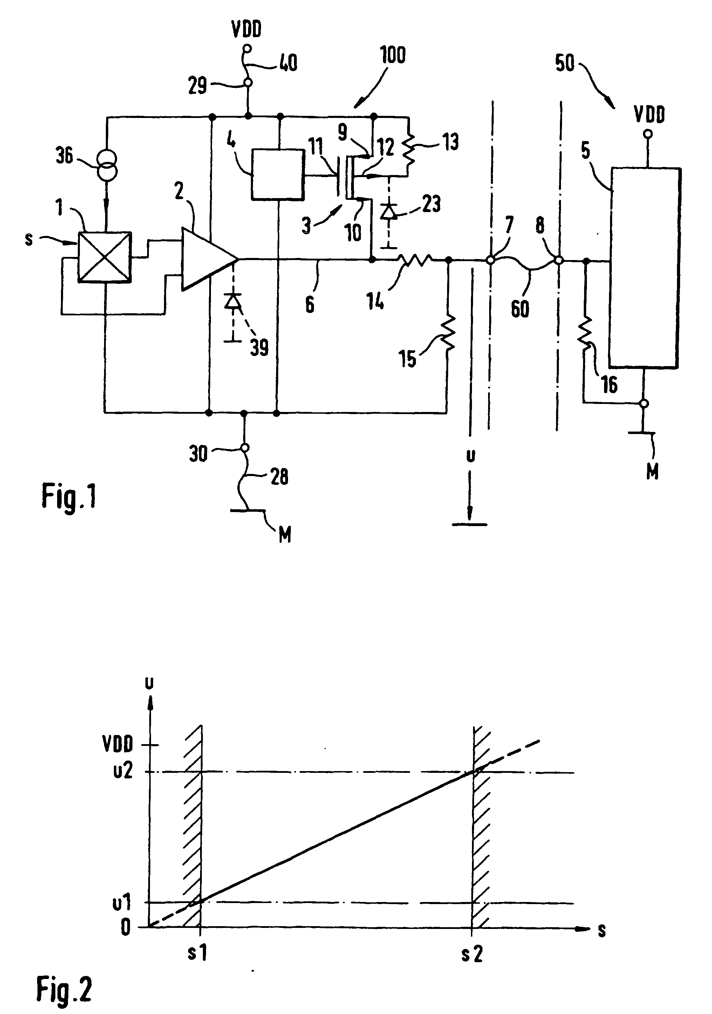

Fig. 1 zeigt schematisch als Blockschaltbild ein Ausführungsbeispiel für eine erfindungsgemäße Gebereinrichtung 100 mit einem Sensor 1. Über eine externe Signalleitung 60 liefert die Gebereinrichtung entsprechend dem Wert des zu messenden externen Zustandes s Sensorsignale an eine Empfangseinrichtung 50, beispielsweise als ein analoges Signal, nämlich eine Ausgangsspannung u am Signalausgang 7. Die Abhängigkeit kann dabei linear sein oder einer vorgegebenen Kurve folgen. Die Gebereinrichtung 100 enthält den schematisch dargestellten Sensor 1, der beispielsweise ein von einer Stromquelle 36 gespeister Hallsensor sein kann, einen Verstärker 2, einen p-Kanal-Depletion-Transistor 3 in MOS-Technik und eine Ladungspumpe 4. Die Betriebsspannung VDD wird über eine externe Betriebsspannungszuleitung 40 einem Betriebsspannungsanschluß 29 und das Massepotential M über eine externe Massezuleitung 28 einem Masseanschluß 30 zugeführt. Der Sensor 1 gibt an seinen Analogausgängen ein Sensorsignal als Differenzsignal ab, welches dem Differenzeingang des Verstärkers 2 zugeführt wird. Das Sensorsignal wird in dem Verstärker 2 definiert verstärkt und auf eine interne Signalleitung 6 gegeben, die mit einem Signalausgang 7 der Gebereinrichtung 100 über einen Schutzwiderstand 14 verbunden ist. Der Schutzwiderstand 14 schützt den Signalausgang 7 und die zugehörigen Schaltungsteile, falls an ihm eine negativere Spannung angelegt wird als am Anschluß 30 für das Massepotential M. Dies tritt beispielsweise beim versehentlichen Anlegen des Massepotentials M an den Signalausgang 7 und der Betriebsspannung VDD an den Masseanschluß 30 auf. In dem Blockschaltbild von Fig. 1 sind die Wanne-Substrat-Diode 23 des p-Kanal-Depletion-Transistors 3 und die Drain-Substrat-Diode des n-Kanal-Transistors, die bei einer üblichen Gegentaktendstufe des Verstärkers 2 als parasitäres Element vorhanden ist, schematisch als gestrichelte Diodensymbole dargestellt. Beim Vertauschen der Anschlüsse 29, 30, 7 sind die Flußstrecken dieser Dioden zu berücksichtigen.

Die Ausgangsspannung u wird von der Empfangseinrichtung 50 mittels einer Signalerkennungseinrichtung 5 ausgewertet, deren Signaleingang 8 über eine mehr oder weniger lange externe Signalleitung 60 mit dem Signalausgang 7 der Gebereinrichtung 100 verbunden ist. Bei einer Betriebsspannung VDD von 5 Volt umfaßt die Ausgangsspannung u im Normalfall einen mittleren Spannungsbereich zwischen der Betriebsspannung VDD und dem Massepotential M, der beispielsweise zwischen 0.5 Volt und 4.5 Volt liegt. Ausgangsspannungen u außerhalb dieses Bereichs werden von der Signalerkennungseinrichtung 5 als Fehlersignale erkannt und weisen auf einen Fehlerzustand des Gesamtsystems, insbesondere aber der Gebereinrichtung 100 oder der Signalleitung 60 hin.

Der p-Kanal-Depletion-Transistor 3 weist einen Source-Anschluß 9, einen Drain-Anschluß 10, einen Gate-Anschluß 11 und einen Wanne-Anschluß 12 auf, wobei der Source-Anschluß 9 mit dem Betriebsspannungsanschluß 29, der Drain-Anschluß 10 mit der internen Signalleitung 6, der Gate-Anschluß 11 mit einem Ausgang der Ladungspumpe 4 und der Wannen- Anschluß 12 über einen ersten Widerstand 13 gemeinsam mit dem Source-Anschluß 9 und dem Betriebsspannungsanschluß 29 verbunden ist. Der Widerstand 13 dient wie bereits erwähnt dem Schutz gegenüber einer Vertauschung des Betriebsspannungs- und Masseanschlusses. Der Signalausgang 7 ist über einen zweiten Widerstand 15 mit dem Masseanschluß 30 verbunden und der Signaleingang 8 der Signalerkennungseinrichtung 5 über einen dritten Widerstand 16 mit dem dortigen Massepotential M. Wie bereits angegeben dient dies der Erkennung einer Unterbrechung der externen Signalleitung 60.

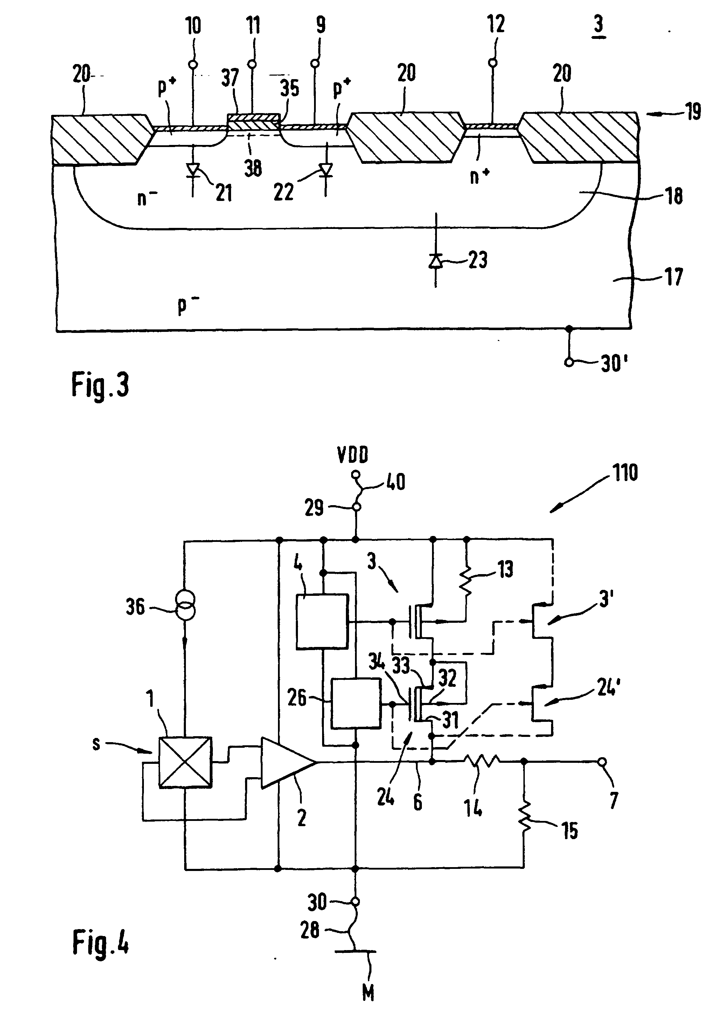

Bei einer normalen Betriebsspannung VDD, z.B. +5 V, soll die Ladungspumpe 4 an ihrem Ausgang eine Gate-Spannung an den Transistor 3 liefern, welche höher ist als die Summe aus der positiven Betriebsspannung VDD und einer positiven Abschnürspannung VTH des Transistors 3. Dadurch wird sein p-leitender Depletion-Kanal 38 (vgl. Fig. 3) vollständig abgeschnürt und gesperrt, so daß kein Strom mehr zwischen dem Source- und Drain-Anschluß 9 bzw. 10 fließen kann. Damit ist Transistor 3 in einen nichtleitenden Zustand gebracht und das verstärkte Sensorsignal gelangt unbeeinflußt an den Signalausgang 7 und ist so einem Zustandswert s zuordenbar.

Tritt eine Unterbrechung der Zuleitung 28 für das Massepotential M auf, so wird die Ladungspumpe 4 außer Betrieb gesetzt und die Gate-Spannung am Transistor 3, die höher als die Betriebsspannung VDD ist, fällt ab. Hierdurch wird der Transistor 3 leitend und zieht den Signalausgang 7 etwa auf den Wert der Betriebsspannung VDD, beispielsweise etwa auf die üblichen 5 Volt. Die Signalerkennungseinrichtung 5 interpretiert nun diesen Wert der Ausgangsspannung u als das Vorliegen eines Fehlerzustandes. Bei einer Unterbrechung der Zuleitung 40 für die Betriebsspannung VDD wird die Ladungspumpe 4 natürlich ebenfalls außer Betrieb gesetzt. Ohne Betriebsspannung VDD nimmt der Signalausgang 7 das Massepotential M an oder bleibt ohne einen der Widerstände 15, 16 allenfalls in einem Schwebezustand.

Kommt es zu einer Unterbrechung der relativ langen Signalleitung 60, so zieht der dritte Widerstand 16 den Signaleingang 8 der Signalerkennungseinrichtung 5 gegen Masse. Die Signalerkennungseinrichtung 5 interpretiert dann diesen Wert der Ausgangsspannung u wiederum als das Vorliegen eines Fehlerzustandes.

Das in Fig. 2 dargestellte Schaubild zeigt den Verlauf der Ausgangsspannung u der Gebereinrichtung 100 in Abhängigkeit von dem zu messenden Zustandwert s. In der Regel ist der zu messende Bereich des Zustandwertes s durch physikalische und/oder mechanische Vorgaben begrenzt, was in Fig. 2 durch einen ersten und zweiten Zustandswert s1, s2 dargestellt ist. Die Verstärkung des Sensorsignals ist an diese Zustandswerte s1, s2 angepaßt, so daß der Aussteuerungsbereich der Ausgangsspannung u diese Zustandswerte s1, s2 als erster und zweiter Grenzwert u1, u2 in seinem Aussteuerbereich enthält. Beispielsweise bieten sich bei einer Betriebsspannung VDD von 5 Volt als zweckmäßige Grenzwerte 0,5 Volt bzw. 4,5 Volt an. Sieht dann die Empfangseinrichtung 50 am Signaleingang 8 eine Spannung u zwischen 0 Volt und 0.5 Volt oder eine Spannung u oberhalb von 4.5 Volt, dann werden diese Spannungen u als das Vorliegen eines Fehlerzustandes interpretiert. Bei Spannungen u zwischen 0,5 Volt und 4,5 Volt hingegen, wird die Höhe der Spannung u als ein gemessener Zustandswert s interpretiert.

Fig. 3 zeigt als übliches Schnittbild schematisch den Aufbau des monolithisch integrierten p-Kanal-Depletion-Transistors 3, im folgenden vereinfachend meist als Transistor 3 bezeichnet. In einem p-Substrat 17 ist eine n-Wanne 18 eingebettet. An einer Oberseite 19 der n-Wanne 18 befinden sich der Source-Anschluß 9, der Drain-Anschluß 10, der Gate-Anschluß 11 und der Wanne-Anschluß 12. Der Source-Anschluß 9 und der Drain-10 sind jeweils mit einer p+ -Zone innerhalb der n-Wanne 18 kontaktiert. Der Gate-Anschluß 11 ist mit einer Gate-Elektrode aus polykristallinem Silizium 37 oder einer Metallschicht verbunden, und der Wanne-Anschluß 12 ist mittels einer n+ -Zone innerhalb der n-Wanne 18 gebildet. Schematisch dargestellt sind ferner die dünne Gate-Oxidschicht 35 und die p-leitende Kanalzone 38 direkt darunter. Schließlich sind im Schnittbild zu den einzelnen Sperrschichten die Diodensybole dargestellt, damit bei einer Vertauschung der Anschlüsse die den einzelnen Sperrschichten zugeordneten Stromflußrichtungen deutlich erkennbar sind. Dargestellt sind die Drain-Wanne-Diode 21, die Source-Wanne-Diode 22 und die Wanne-Substrat-Diode 23. Zur Isolation sind Feldoxidschichten 20, die an die n⁺- oder p⁺-Zonen angrenzen, zwischen dem Source-Anschluß 9 und dem Wanne-Anschluß 12 vorgesehen. Da der Depletion-Transistor 3 vom p-Kanal-Typ ist, nimmt der Strom zwischen Source und Drain mit zunehmender Spannung am Gate-Anschluß 11 ab.

Kommt es zu einem Vertauschen der Anschlüsse 29 bzw. 30 für die Betriebsspannung VDD und das Massepotential M, so wird die Wanne-Substrat-Diode 23 leitend. Im Verpolungsfall fließt somit ein Strom vom Substrat 17, das beispielsweise über einen eigenen Substratanschluß 30' leitend mit dem Masseanschluß 30 verbunden ist, über die Wanne-Substrat-Diode 23 zum Wanne-Anschluß 12. Ein zu starkes Ansteigen dieses Verpolungsstromes wird durch den in Fig. 1 dargestellten separaten Widerstand 13 verhindert, der beispielsweise als ein Polysiliziumwiderstand ausgebildet ist, zwischen dem Wanne-Anschluß 12 und dem Source-Anschluß 9 angeschlossen ist und durch seine strombegrenzende Wirkung im Verpolungsfall Transistor 3 gegen Zerstörung durch Überhitzung schützt.

Fig. 4 zeigt ein weiteres Ausführungsbeispiel einer Gebereinrichtung 110 mit Schutzmaßnahmen gegen Überspannungen am Betriebsspannungsanschluß 29. Um den DepletionTransistor 3 vor Überspannung zu schützen, ist zu ihm in Reihe ein p-Kanal-Depletion-Kaskodetransistor 24 angeordnet, der im folgenden vereinfachend meist als Kaskodetransistor 24 bezeichnet wird. Sein Source-Anschluß 33 ist an den Transistor 3 und sein Drain-Anschluß 31 an die interne Signalleitung 6 angeschlossen. Ein Gate-Anschluß 34 des Kaskodetransistors 24 ist mit einer Ansteuerschaltung 26 verbunden. Die Ansteuerschaltung 26 ist mit dem Betriebsspannungs- 29 und Masseanschluß 30 gekoppelt und liefert zur Ansteuerung des Kaskodetransistors 24 eine Spannung, die etwa in der Mitte zwischen der Betriebspannung VDD und dem Massepotential M liegt. Tritt im Betrieb eine Überspannung am Betriebsspannungsanschluß 29 auf, so fällt diese entsprechend der vorgegebenen Kaskodeansteuerspannung etwa hälftig über den gesperrten Transistor 3 und den im leitenden Zustand befindlichen Kaskodetransistor 24 ab, so daß eine unzulässige Überspannung am Transistors 3 und am Kaskodetransistor 24 vermieden wird. Bei der in Fig. 4 dargestellten Schaltungsanordnung mit Überspannungsschutz sind parallel zu der Reihenschaltung aus Transistor 3 und Kaskodetransistor 24 alternativ zwei in Reihe geschaltete Depletion-Sperrschicht-Feldeffekttransistoren 3', 24' angeordnet, deren Steuerelektroden von der Ladungspumpe 4 bzw. der Ansteuerschaltung 26 angesteuert sind. Diese und andere Alternativen können sich beispielsweise aus den jeweils zur Verfügung stehenden Herstellungsprozessen ergeben.

Grundsätzlich ist es auch möglich, für die monolithische Integration ein n-leitendes Substrat vorzusehen und die Leitfähigkeit der einzelnen Zonen entsprechend anzupassen. Diese Schaltungsanordnung funktioniert dann in gleicher Weise hinsichtlich des Erkennens einer Unterbrechung der Masse- oder der Signalleitung wie die vorstehend beschriebenen Ausführungsbeispiele.

Im Ausführungsbeispiel ist die die Erkennung einer Unterbrechung in der Massezuleitung ausführlich beschrieben. Selbstverständlich läßt sich ein von einer Ladungspumpe gesteuerter p-Kanal-Depletion-Transistor auch zwischen den Masseanschluß und den Signalausgang schalten. Bei Unterbrechung der positiven Versorgungsspannung VDD liefert die Ladungspumpe keine Ausgangsspannung und somit wird über den leitenden p-Kanal-Depletion-Transistor der Signalausgang zwangsweise auf das Massepotential gezogen. Das kann dann von Interesse sein, wenn beispielsweise der Signalausgang als offener Drain-Ausgang ausgebildet ist und der Empfänger das digitale Sensorsignal über das jeweilige Potential an einem Lastwiderstand als "Hoch-" oder "Tief-Zustand" erfasst.

In diesem Fall würde dieser "pull-up"-Widerstand ein positives Potential vortäuschen, obwohl am Geber die positive Versorgungsleitung unterbrochen ist. Der Widerstand des p-Kanal-Depletion-Transistors soll im leitenden Fall klein gegen den "pull-up'"-Widerstand sein, damit die Spannung am Signalausgang möglichst dicht beim Massepotential liegt, möglichst noch unterhalb des üblichen "Tief"-Wertes.

### Bezugszeichenliste

- 1: Sensor
- 2: Verstärker
- 3: p-Kanal-Depletion-Transistor (MOS-Ausführung)
- 3': erster Depletion-Sperrschicht-Feldeffekttransistor
- 4: Ladungspumpe
- 5: Signalerkennungseinrichtung
- 6: interne Signalleitung
- 7: Signalausgang
- 8: Signaleingang
- 9: Source-Anschluß (des p-Kanal-Depletion-Transistors 3)
- 10: Drain-Anschluß (des p-Kanal-Depletion-Transistors 3)
- 11: Gate-Anschluß (des p-Kanal-Depletion-Transistors 3)
- 12: Wanne-Anschluß (des p-Kanal-Depletion-Transistors 3)
- 13: erster Widerstand
- 14: Schutzwiderstand
- 15: zweiter Widerstand
- 16: dritter Widerstand
- 17: p-Substrat
- 18: n-Wanne (des p-Kanal-Depletion-Transistors 3)
- 19: Oberseite
- 20: Feldoxidschicht
- 21: Drain-Wanne-Diode (des p-Kanal-Depletion-Transistors 3)
- 22: Source-Wanne-Diode (des p-Kanal-Depletion-Transistors 3)
- 23: Wanne-Substrat-Diode (des p-Kanal-Depletion-Transistors 3)
- 24: p-Kanal-Depletion-Kaskodetransistor (MOS-Ausführung)
- 24': zweiter Depletion-Sperrschicht- Feldeffekttransistor
- 26: Ansteuerschaltung
- 28: Masseleitung
- 29: Betriebsspannungsanschluß
- 30: Masseanschluß
- 30': Substratanschluß
- 31: Drain-Anschluß (des p-Kanal-Depletion-Kaskodetransistors 24)
- 32: n-Wanne-Anschluß (des p-Kanal-Depletion-Kaskodetransistors 24)
- 33: Source-Anschluß des (p-Kanal-Depletion-Kaskodetransistors 24)
- 34: Gate-Anschluß (des p-Kanal-Depletion-Kaskodetransistors 24)
- 35: Gateoxid
- 36: Stromquelle
- 37: Gate-Elektrode (des p-Kanal-Depletion-Transistors 3)
- 38: p-dotierter Kanal (des p-Kanal-Depletion-Transistors 3)
- 39: Drain-Substrat-Diode bei n-Kanal-Transistor der CMOS-Gegentaktendstufe
- 40: Betriebsspannungszuleitung
- 50: Empfangseinrichtung
- 60: externe Signalleitung
- 100: Gebereinrichtung
- 110: weitere Gebereinrichtung
- s: (vom Sensor zu erfassender externer) Zustandswert
- s1 s2: erster / zweiter Zustandswert
- u: Ausgangsspannung
- u1 u2: erster / zweiter Grenzwert
- M: Massepotential
- VDD: Betriebsspannung

## Patentansprüche

1. Gebereinrichtung (100; 110) mit einer Fehlermeldeschaltung (3, 4), die bei Unterbrechung einer Massezuleitung (28) über einen steuerbaren Widerstand ein vorgegebenes Potential an einem Signalausgang (7) erzwingt,
**gekennzeichnet durch** folgende Merkmale:
- die Fehlermeldeschaltung (3, 4) enthält als steuerbaren Widerstand einen p-Kanal-Depletion-Transistor (3), der in einer n-Wanne (18) eines p-leitenden Substrats (17) liegt und der mit einem Betriebsspannungsanschluß (29) und dem Signalausgang (7) verkoppelt ist,
- die n-Wanne (18) des p-Kanal-Depletion-Transistors (3) ist über einen ersten, insbesondere mitintegrierten, Widerstand (13) mit dem Betriebsspannungsanschluß (29) verbunden,
- der Gate-Anschluß (11) des p-Kanal-Depletion-Transistors (3) ist mittels einer zwischen dem Betriebsspannungs- (29) und dem Masseanschluß (30) liegenden Ladungspumpe (4) gesteuert, und
- die Ausgangsspannung der Ladungspumpe (4) ist im normalen Betriebszustand ausreichend hoch, um den p-Kanal-Depletion-Transistors (3) zu sperren, wohingegen im Unterbrechungsfall der Massezuleitung (28) der p-Kanal-Depletion-Transistor (3) leitend ist und **dadurch** den Signalausgang (7) etwa auf die Betriebsspannung (VDD) zieht.

2. Gebereinrichtung (100; 110) nach Anspruch 1,
**dadurch gekennzeichnet,**
**daß** der Signalausgang (7) mittels eines zweiten, insbesondere mitintegrierten, Widerstandes (15) mit dem Masseanschluß (30) verbunden ist.

3. Gebereinrichtung (100; 110) nach nach Anspruch 2,
**dadurch gekennzeichnet,**
**daß** in einer Signalleitung (6) der Gebereinrichtung (100; 110) ein Schutzwiderstand (14), der insbesondere mitintegiert ist, vor dem Signalausgang (7) vorgesehen ist, der den Stromfluß beim Anlegen einer Spannung an den Signalausgang (7) begrenzt.

4. Gebereinrichtung (100; 110) nach einem der Ansprüche 1 bis 3,
**gekennzeichnet durch** folgende Merkmale:
- ein p-Kanal-Depletion-Kaskodetransistor (24) liegt in Reihe zu dem p-Kanal-Depletion-Transistor (3),
- eine dem p-Kanal-Depletion-Kaskodetransistor (24) zugehörige n-Wanne (32) ist mit einem Source-Anschluß (33) des p-Kanal-Depletion-Kaskodetransistors (24) verbunden,
- der Gate-Anschluß (34) des p-Kanal-Depletion-Kaskodetransistors (24) ist von einer zwischen dem Betriebsspannungs- (29) und dem Masseanschluß (30) liegenden Ansteuerschaltung (26) gesteuert,
- die Ausgangsspannung der Ansteuerschaltung (26) liegt im normalen Betriebszustand etwa auf halber Betriebsspannung (VDD).

5. Gebereinrichtung (100; 110) nach Anspruch 1, **dadurch gekennzeichnet, daß** der p-Kanal-Depletion-Transistor (3) durch einen ersten Depletion-Sperrschicht-Feldeffekttransistor (3') ersetzt ist.

6. Gebereinrichtung (100; 110) nach Anspruch 4, **dadurch gekennzeichnet, daß** der p-Kanal-Depletion-Kaskodetransistor (24) und/oder der p-Kanal-Depletion-Transistor (3) durch einen zweiten bzw. einen ersten Depletion-Sperrschicht-Feldeffekttransistor (24' bzw. 3') ersetzt sind.

7. Gebereinrichtung (100; 110) nach einem der Ansprüche 1 bis 6, **dadurch gekennzeichnet, daß** für die monolithische Integration ein n-leitendes Substrat verwendet ist und die Leitfähigkeit der verschiedenen Zonen entsprechend angepaßt sind.

8. Gebereinrichtung (100; 110) nach einem der Ansprüche 1 bis 7, **dadurch gekennzeichnet, daß** der Signalausgang (7) über eine externe Signalleitung (60) mit einer Empfangseinrichtung (50) verbunden ist, die eine Signalerkennungseinrichtung (5) enthält und in Abhängigkeit von der jeweiligen Höhe des an einem Signaleingang (8) abgreifbaren Spannungswertes (u) das Vorliegen eines auswertbaren Gebersignals oder eines Fehlerzustandes erkennt.

9. Gebereinrichtung (100; 110) nach Anspruch 8, **dadurch gekennzeichnet, daß** der Eingang (8) der Signalerkennungseinrichtung (5) mittels eines dritten Widerstandes (16) mit dem Massepotential (M) verbunden ist.

10. Gebereinrichtung (100; 110) mit einer Fehlermeldeschaltung (3, 4), die bei Unterbrechung einer Versorgungszuleitung (28, 40) über einen steuerbaren Widerstand ein vorgegebenes Potential an einem Signalausgang (7) erzwingt,
**gekennzeichnet durch** folgende Merkmale:
- die Fehlermeldeschaltung (3, 4) enthält als steuerbaren Widerstand einen p-Kanal-Depletion-Transistor (3), der in einer n-Wanne (18) eines p-leitenden Substrats (17) liegt und der mit einem, insbesondere einem nicht zu überwachenden, Versorgungsanschluß (30, 29) und dem Signalausgang (7) verkoppelt ist,
- die n-Wanne (18) des p-Kanal-Depletion-Transistors (3) ist über einen ersten, insbesondere mitintegrierten, Widerstand (13) mit dem Betriebsspannungsanschluß (29) verbunden,
- der Gate-Anschluß (11) des p-Kanal-Depletion-Transistors (3) ist mittels einer zwischen dem Betriebsspannungs- (29) und dem Masseanschluß (30) liegenden Ladungspumpe (4) gesteuert, und
- die Ausgangsspannung der Ladungspumpe (4) ist im normalen Betriebszustand ausreichend hoch, um den p-Kanal-Depletion-Transistors (3) zu sperren, wohingegen im Unterbrechungsfall die Ladungspumpe (4) den p-Kanal-Depletion-Transistor (3) nicht mehr sperren kann, wodurch dieser den Signalausgang (7) etwa auf das am anderen Anschluß des p-Kanal-Depletion-Transistors (3) vorhandene Potential (VDD, M) zieht.

## Claims

1. A transducer device (100; 110) comprising a fault indicating circuit (3, 4) which in the event of a break occurring in a ground lead (28) forces a predetermined potential at a signal output (7) via a controllable resistance element,
**characterized by** the following features:
- The fault indicating circuit (3, 4) includes as the controllable resistance element a p-channel depletion-mode transistor (3) which lies in an n-type well (18) of a p-type substrate (17) and which is coupled to a supply voltage terminal (29) and the signal output (7);
- the n-type well (18) of the p-channel depletion-mode transistor (3) is connected to the supply voltage terminal (29) through a first resistor (13), particularly through an integrated resistor;
- the gate terminal (11) of the p-channel depletion-mode transistor (3) is controlled by means of a charge pump (4) connected between the supply voltage terminal (29) and the ground terminal (30); and
- in the normal operating condition, the output voltage of the charge pump (4) is high enough to turn the p-channel depletion-mode transistor (3) off, whereas when the ground lead (28) is broken, the p-channel depletion-mode transistor (3) is on and thereby pulls the signal output (7) approximately to the supply voltage (VDD).

2. A transducer device (100; 110) as claimed in claim 1,
**characterized in**
**that** the signal output (7) is connected to the ground terminal (30) through a second resistor (15), particularly through an integrated resistor.

3. A transducer device (100; 110) as claimed in claim 2,
**characterized in**
**that** in a signal line (6) of the transducer device (100; 110), a protective resistor (14), particularly an integrated resistor, which limits the flow of current on application of a voltage to the signal output (7), is provided ahead of the signal output (7).

4. A transducer device (100; 110) as claimed in any one of claims 1 to 3,
**characterized by** the following features:
- A p-channel depletion-mode cascode transistor (24) is connected in series with the p-channel depletion-mode transistor (3);
- an n-type well (32) of the p-channel depletion-mode cascode transistor (24) is connected to a source terminal (33) of the p-channel depletion-mode cascode transistor (24);
- the gate terminal (34) of the p-channel depletion-mode cascode transistor (24) is controlled by a control circuit (26) connected between the supply voltage terminal (29) and the ground terminal (30); and
- in the normal operating condition, the output voltage of the control circuit (26) is approximately one-half of the supply voltage (VDD).

5. A transducer device (100; 110) as claimed in claim 1, **characterized in that** the p-channel depletion-mode transistor (3) is replaced by a first depletion-mode junction field-effect transistor (3').

6. A transducer device (100; 110) as claimed in claim 4, **characterized in that** the p-channel depletion-mode cascode transistor (24) and/or the p-channel depletion-mode transistor (3) are replaced by a second depletion-mode junction field-effect transistor (24') and/or a first depletion-mode junction field-effect transistor (3'), respectively.

7. A transducer device (100; 110) as claimed in any one of claims 1 to 6, **characterized in that** for monolithic integration, an n-type substrate is used and the conductivity of the various regions is adapted accordingly.

8. A transducer device (100; 110) as claimed in any one of claims 1 to 7, **characterized in that** the signal output (7) is connected via an external signal line (60) to a receiving device (50) which comprises a signal interpreting device (5) and detects the presence of an interpretable transducer signal or a fault condition based on the respective voltage level appearing at a signal input (8).

9. A transducer device (100; 110) as claimed in claim 8, **characterized in that** the input (8) of the signal interpreting device (5) is connected to ground potential (M) through a third resistor (16).

10. A transducer device (100; 110) comprising a fault indicating circuit (3, 4) which in the event of a break occurring in a supply lead (28, 40) forces a predetermined potential at a signal output (7) via a controllable resistance element,
**characterized by** the following features:
- The fault indicating circuit (3, 4) comprises as the controllable resistance element a p-channel depletion-mode transistor (3) which lies in an n-type well (18) of a p-type substrate (17) and which is coupled to a supply terminal (30, 29), particularly a supply terminal not to be monitored, and to the signal output (7);
- the n-type well (18) of the p-channel depletion-mode transistor (3) is connected to the supply voltage terminal (29) through a first resistor (13), particularly through an integrated resistor;
- the gate terminal (11) of the p-channel depletion-mode transistor (3) is controlled by means of a charge pump (4) connected between the supply voltage terminal (29) and the ground terminal (30); and
- in the normal operating condition, the output voltage of the charge pump (4) is high enough to turn the p-channel depletion-mode transistor (3) off, whereas on the occurrence of a break, the charge pump (4) cannot turn the p-channel depletion-mode transistor (3) off, whereby the p-channel depletion-mode transistor (3) pulls the signal output (7) to approximately the potential (VDD, M) present at the other terminal of the p-channel depletion-mode transistor (3).

## Revendications

1. Capteur électronique (100 ; 110) comportant un circuit de signalisation d'états de fonctionnement (3, 4) qui force une sortie de signal (7) à un potentiel donné au moyen d'une résistance commandable lors de l'interruption d'un conducteur de mise à la masse (28),
**caractérisé en ce que**
- le circuit de signalisation d'états de fonctionnement (3, 4) contient à titre de résistance commandable un transistor à déplétion à canal p (3) dans lequel se trouve un substrat de type p (17) dans un puits de type n et qui est couplé à une connexion (29) de tension d'alimentation et à la sortie de signal (7) ;
- le puits (18) de type n du transistor (3) à déplétion de canal p est associé avec, plus particulièrement intégré en même temps que, la connexion de tension d'alimentation (29) avec une première résistance (13) ;
- la connexion de grille (11) du transistor à déplétion de canal p (3) est pilotée au moyen d'une pompe de charges (4) qui se trouve entre les connexions d'alimentation en tension (29) et de mise à la masse (30) ;
- la tension de sortie de la pompe de charges (4) est à un niveau suffisamment haut lors d'un état de fonctionnement normal afin que le transistor à déplétion à canal p (3) soit bloqué, tandis que lors d'une interruption du conducteur (28) de mise à la masse, le transistor (3) à déplétion à canal p est conducteur et de sorte que la sortie (7) de signal est portée à une valeur proche de la tension d'alimentation (VDD).

2. Capteur électronique selon la revendication 1, **caractérisé en ce que** la sortie (7) de signal est reliée à une seconde résistance (15), en particulier intégrée avec la connexion de masse (30).

3. Capteur électronique selon la revendication 2, **caractérisé en ce que** une résistance de protection (14) est disposée en amont de la sortie de signal (7) sur le conducteur de signal (6) du capteur électronique (100 ; 110), en particulier la résistance de protection étant intégrée avec la sortie de signal, la résistance de protection limitant le flux de courant par création d'une tension sur la sortie de signal (7).

4. Capteur électronique (100; 110) selon l'une quelconque des revendications 1 à 3, **caractérisé en ce que**
- un montage « cascode » est basé sur un transistor (24) à déplétion à canal p disposé en série avec le transistor (3) à déplétion à canal p ;
- un puits de type n correspondant au transistor (24) à déplétion à canal p est associé avec une connexion de source (33) du transistor (24) à déplétion à canal p du montage « cascode »;
- la connexion de grille (34) du transistor (24) à déplétion à canal p du montage « cascode » est commandée au moyen d'un circuit de commande (26) disposé entre les connexions d'alimentation en tension (29) et de mise à la masse (30) ; et/ou
- la tension de sortie du circuit de commande (26) est placée dans un état normal de fonctionnement à une tension moitié de la tension d'alimentation (VDD).

5. Capteur électronique selon la revendication 1, **caractérisé en ce que** le transistor (23) à déplétion à canal p est remplacé par un premier transistor (3') à effet de champ à déplétion à couche de commande.

6. Capteur électronique (100 ; 110) selon la revendication 4, **caractérisé en ce que** le transistor (24) à déplétion à canal p et/ou le transistor (3) à déplétion à canal p sont remplacés par un second (24') et/ou un premier (3') transistor à effet de champ à déplétion à couche de commande.

7. Capteur électronique (100 ; 110) selon l'une quelconque des revendications 1 à 6, **caractérisé en ce que** un substrat conducteur de type n est utilisé pour l'intégration monolithique et la conductivité des diverses zones correspondantes est adaptée.

8. Capteur électronique (100; 110) selon l'une quelconque des revendications 1 à 7, **caractérisé en ce que** la sortie de signal (7) est reliée par un conducteur (60) de signal externe à un circuit émetteur (50) qui contient un circuit générateur de signal (50) et qui, en fonction de la hauteur respective d'une valeur détectable (u) d'une entrée de signal (8), reconnaît la disponibilité d'un signal de détection du capteur ou d'un état de fonctionnement du capteur.

9. Capteur électronique (100 ; 110) selon la revendication 8, **caractérisé en ce que** l'entrée (8) du circuit (5) de reconnaissance de signa est connectée au potentiel de masse (M) au moyen d'une troisième résistance (16).

10. Capteur électronique (100 ; 110) muni d'un circuit de signalisation d'états de fonctionnement (3, 4) qui force une sortie de signal (7) à un potentiel donné au moyen d'une résistance commandable lors de l'interruption d'un conducteur de mise à la polarisation (28, 40),
**caractérisé en ce que**
- le circuit de signalisation d'états de fonctionnement (3, 4) contient à titre de résistance commandable un transistor à déplétion à canal p (3) dans lequel se trouve un substrat de type p (17) dans un puits de type n et qui est couplé à une connexion (30, 29) de mise à la polarisation, en particulier qui n'est pas à surveiller, et à la sortie de signal (7) ;
- le puits (18) de type n du transistor (3) à déplétion de canal p est associé avec, plus particulièrement intégré en même temps que, la connexion de tension d'alimentation (29) avec une première résistance (13) ;
- la connexion de grille (11) du transistor à déplétion de canal p (3) est pilotée au moyen d'une pompe de charges (4) qui se trouve entre les connexions d'alimentation en tension (29) et de mise à la masse (30) ;
- la tension de sortie de la pompe de charges (4) est à un niveau suffisamment haut lors d'un état de fonctionnement normal afin que le transistor à déplétion à canal p (3) soit bloqué, tandis que lors d'une interruption de la pompe de charges (4) qui ne peut plus suffisamment bloquer le transistor (3) à déplétion à canal p, la sortie (7) de signal est portée à une valeur proche du potentiel prévu (VDD, M) de l'autre connexion du transistor (3) à déplétion à canal p.
